# EUROPEAN PATENT SPECIFICATION

(11) **EP 4 462 480 B1**
(45) Date of publication and mention of the grant of the patent: **25.03.2026**
(21) Application number: 24718694.3
(22) Date of filing: 11.01.2024
(51) Int. Cl.: H01L 23/367, H01L 23/538, H01L 23/66, H01L 21/48, H01L 23/498, H01L 23/522, H01L 23/00, H02M 7/00, H01L 25/065, H01L 25/07, H01L 25/16

(54) **POWER MODULE, POWER CONVERSION DEVICE, AND VEHICLE**
LEISTUNGSMODUL, LEISTUNGSUMWANDLUNGSVORRICHTUNG UND FAHRZEUG
MODULE D'ALIMENTATION, DISPOSITIF DE CONVERSION DE PUISSANCE ET VÉHICULE

(30) Priority: 23.03.2023 CN 202310327436
(43) Date of publication of application: 13.11.2024
(73) Proprietor: Huawei Digital Power Technologies Co., Ltd., Shenzhen, Guangdong 518043 (CN)
(72) Inventor: PENG, Hao, Shenzhen Guangdong 518043 (CN); LIAO, Xiaojing, Shenzhen Guangdong 518043 (CN)
(74) Representative: Gill Jennings & Every LLP
(86) International application number: PCT/CN2024/071795
(87) International publication number: WO 2024/193200

(56) References cited:
- CN-A- 104 900 634
- CN-A- 105 870 092
- CN-A- 105 870 092
- CN-A- 106 787 897
- CN-A- 112 042 283
- CN-A- 115 732 479
- CN-A- 115 732 479
- CN-A- 116 504 751
- US-A1- 2021 175 184
- US-A1- 2022 384 308
- US-B1- 9 107 290

## Description

### TECHNICAL FIELD

This application relates to the field of semiconductor technologies, and in particular, to a power module, a power conversion device, and a vehicle.

### BACKGROUND

A power semiconductor is a core of electric energy conversion and circuit control in an electronic apparatus, and mainly implements functions of power switches and electric power conversion based on unidirectional conductivity of the semiconductor, so that energy conversion efficiency can be improved, and a power loss can be reduced. Specific functions of the power semiconductor include frequency conversion, phase conversion, voltage conversion, inversion, rectification, amplification, conduction/disconnection, and the like. A power module (Power Module) integrates a plurality of power semiconductors and insulation components. Compared with single-transistor packaging, the power module features high integration, convenient assembly, and high reliability.

In a related technology, the power module may include a circuit board and a plurality of chips integrated on a surface of the circuit board. The chips may be electrically connected to a packaging substrate through wire bonding (Wire Bonding). A first pad is disposed on the chip, and a second pad is disposed on the circuit board. One end of a lead is connected to the first pad, and the other end of the lead is connected to the second pad.

However, integration of the foregoing power module needs to be improved. US 9107290 B1 discloses a package structure including two insulation layers, three conductive layers, and two electronic components. US 2022/284308 A1 discloses a semiconductor package structure including a first electronic component, a conductive element and a first redistribution structure. CN 105870092 A discloses a package structure having an electronic component and a redistribution layer, wherein the conductive terminal of the electronic component is electrically connected to an external circuit through a redistribution layer, that can realize a high-density electronic component package. CN 115732479 A discloses a power converter module including a power transistor, a substrate, and an interconnect configured to provide a connection to a system bus. US 2021/175184 A1 discloses a power module assembly including a package body, a first wiring layer, a capacitor, and a system bus set. CN 106787897 A discloses a system for converting DC power into three-phase alternating current power, comprising three switch arms.

### SUMMARY

Embodiments of this application provide a power module, a power conversion device, and a vehicle, to improve integration of the power module, to further improve performance of the power conversion device and the vehicle.

A first aspect of embodiments of this application provides a power module, including an insulation layer, a plurality of conductive layers, a decoupling capacitor, and a plurality of first components. The insulation layer includes a plurality of sub-insulation layers stacked in a thickness direction of the power module, and the sub-insulation layer is disposed between every two adjacent conductive layers; the power module includes a first region, a sub-insulation layer located in the first region has a first accommodation cavity, the first component is located in the first accommodation cavity, the conductive layer adjacent to the sub-insulation layer at which the first component is disposed is electrically connected to the first component, and at least some of the first components are stacked in the thickness direction of the power module; and the insulation layer located in the first region has an auxiliary accommodation cavity, the decoupling capacitor is located in the auxiliary accommodation cavity, a first pin of the decoupling capacitor is electrically connected to one layer of the plurality of conductive layers, and a second pin of the decoupling capacitor is electrically connected to another layer of the plurality of conductive layers.

The power module provided in embodiments of this application may include: the insulation layer, the plurality of conductive layers, the decoupling capacitor, and the plurality of first components. The insulation layer includes the plurality of sub-insulation layers stacked in the thickness direction of the power module, and the sub-insulation layer is disposed between every two adjacent conductive layers. The sub-insulation layer may be configured to electrically isolate two adjacent conductive layers. The power module may include the first region, the sub-insulation layer located in the first region has the first accommodation cavity, the first component may be located in the first accommodation cavity, and the conductive layer adjacent to the sub-insulation layer at which the first component is disposed is electrically connected to the first component. The first component may be electrically connected to another component of the power module and/or an external circuit through the conductive layer, so that connection through wire bonding is avoided. Both a parasitic inductance and a parasitic resistance of the conductive layer are small, and a voltage (current) change rate is reduced. This alleviates a voltage oscillation phenomenon, further alleviates a voltage spike caused to the first component, reduces voltage stress on the first component, and improves a response speed and efficiency of the first component. In this way, costs are reduced, phenomena such as electrical breakdown and thermal damage of the first component are reduced, and the first component is protected. The at least some of the first components may be stacked in the thickness direction of the power module, so that space of the insulation layer in the thickness direction can be fully used, to reduce a plane size of the plurality of first components, reduce a planar area that is of the insulation layer and that is occupied by the plurality of first components, and improve integration of the power module. This improves performance of the power module and reduces manufacturing costs of the power module. In addition, reducing connection areas between the plurality of first components and the insulation layer may further improve stress and deformation that are generated between the plurality of first components and the insulation layer, to reduce a possibility of stripping the first component from the insulation layer. The insulation layer located in the first region may have the auxiliary accommodation cavity, the decoupling capacitor may be located in the auxiliary accommodation cavity, the first pin of the decoupling capacitor may be electrically connected to one layer of the plurality of conductive layers, and the second pin of the decoupling capacitor may be electrically connected to another layer of the plurality of conductive layers. The decoupling capacitor is electrically connected to at least one of the plurality of first components through the conductive layer, and the decoupling capacitor may absorb the voltage spike. This reduces the voltage stress and protects the electrically connected first component.

In a possible implementation, the insulation layer includes a first side and a second side that are disposed opposite to each other in the thickness direction of the power module, and the plurality of conductive layers include a first conductive layer, a second conductive layer, and at least one third conductive layer; and the first conductive layer is located on the first side, the second conductive layer is located on the second side, and the third conductive layer is located between the first conductive layer and the second conductive layer.

In a possible implementation, that the plurality of conductive layers include the at least one third conductive layer includes: There is one third conductive layer, the plurality of sub-insulation layers include a first sub-insulation layer and a second sub-insulation layer, the first sub-insulation layer is located between the first conductive layer and the third conductive layer, and the second sub-insulation layer is located between the second conductive layer and the third conductive layer; the plurality of first components include a first transistor and a second transistor, the first transistor is located in the first sub-insulation layer, and the second transistor is located in the second sub-insulation layer; and a first electrode and a control electrode of the first transistor are electrically connected to the first conductive layer, a second electrode of the first transistor is electrically connected to a first electrode of the second transistor through the third conductive layer, a control electrode of the second transistor is electrically connected to the third conductive layer, and a second electrode of the second transistor is electrically connected to the second conductive layer.

In this way, a quantity of stacked transistors is small, and manufacturing difficulty of the transistors is low. In addition, the transistor is electrically connected to another component of the power module and/or an external circuit through the conductive layer, so that voltage stress on the transistor can be reduced, and a response speed and efficiency of the transistor can be improved. In this way, costs are reduced, phenomena such as electrical breakdown and thermal damage of the transistor are reduced, and the transistor is protected.

In a possible implementation, that a first pin of the decoupling capacitor is electrically connected to one layer of the plurality of conductive layers, and a second pin of the decoupling capacitor is electrically connected to another layer of the plurality of conductive layers includes:
The first pin of the decoupling capacitor is electrically connected to the first electrode of the first transistor through the first conductive layer, and the second pin of the decoupling capacitor is electrically connected to the second electrode of the second transistor through the second conductive layer.

In this way, the decoupling capacitor may absorb the voltage spike. This reduces the voltage stress and protects the electrically connected first component. In addition, the decoupling capacitor is connected to the transistor through the conductive layer, so that the voltage stress on the transistor can be reduced, and the response speed and the efficiency of the transistor can be improved. In this way, costs are reduced, phenomena such as electrical breakdown and thermal damage of the transistor are reduced, and the transistor is protected.

In a possible implementation, the power module further includes an insulation fastener, and the insulation fastener is located between the decoupling capacitor and a cavity wall of the auxiliary accommodation cavity.

In this way, the decoupling capacitor can be better fastened in the auxiliary accommodation cavity, to avoid a case in which the decoupling capacitor is misplaced during subsequent connection to the conductive layer, and reduce assembly difficulty.

In a possible implementation, the power module further includes a first connection portion and a second connection portion, the first connection portion is disposed at the conductive layer electrically connected to the first pin, the first connection portion is electrically connected to the first pin, and a material of the first connection portion is the same as a material of the first pin; and
the second connection portion is disposed at the conductive layer electrically connected to the second pin, the second connection portion is electrically connected to the second pin, and a material of the second connection portion is the same as a material of the second pin.

In this way, connection strength between same materials is high, so that the first connection portion and the first pin, and the second connection portion and the second pin can be better connected together.

In a possible implementation, the conductive layer includes a plurality of sub-conductive layers stacked in the thickness direction of the power module; and two adjacent sub-conductive layers are in contact; or two adjacent sub-conductive layers are disposed at spacings, the sub-insulation layer is disposed between the two adjacent sub-conductive layers, and the two adjacent sub-conductive layers are electrically connected through a conductive hole provided in the sub-insulation layer.

In this way, the two adjacent sub-conductive layers are connected in a large quantity of manners, and are applicable to a large quantity of scenarios.

In a possible implementation, a plurality of sub-conductive layers of a same conductive layer include a first sub-conductive layer and a second sub-conductive layer, and a thickness of the first sub-conductive layer is greater than a thickness of the second sub-conductive layer.

In this way, the first sub-conductive layer has a relatively large thickness, and better heat dissipation effect can be obtained. This improves heat dissipation efficiency of the power module. The second sub-conductive layer has a relatively small thickness, and may form a finer pattern, to improve a pattern density of the sub-conductive layer, shorten manufacturing time, and reduce manufacturing difficulty.

In a possible implementation, a first sub-conductive layer of the first conductive layer is located on a side that is of a second sub-conductive layer of the first conductive layer and that faces away from the second side; and a first sub-conductive layer of the second conductive layer is located on a side that is of a second sub-conductive layer of the second conductive layer and that faces away from the first side.

In this way, a sub-conductive layer with a relatively large thickness (a first sub-conductive layer 131) is closer to a surface of the power module. This is more conducive to heat dissipation of the power module. A sub-conductive layer with a relatively small thickness (the second sub-conductive layer) is closer to a center of the power module, and can prepare a finer and higher-density pattern. This is conducive to meeting complex wiring application in the power module.

In a possible implementation, the power module further includes a plurality of second components, the power module includes a second region, the second region is located on at least one side of the first region, the second component is located in the second region, and the second component is electrically connected to the first component through the conductive layer; and a sum of powers of all the first components is greater than a sum of powers of all the second components.

In this way, functions of the power module can be enriched, an intelligent module can be implemented, and impact of heat in the first region on the second component in the second region can be avoided.

In a possible implementation, the power module further includes a second accommodation cavity, the second accommodation cavity is located at a sub-insulation layer in the second region, and the second component is located in the second accommodation cavity; or
the second component is located on a side that is of at least one of the first conductive layer and the second conductive layer and that faces away from the insulation layer; or
the power module further includes a second accommodation cavity, where the second accommodation cavity is located at a sub-insulation layer in the second region, some of the second components are located in the second accommodation cavity, and the other part of the second components are located on a side that is of at least one of the first conductive layer and the second conductive layer and that faces away from the insulation layer.

In this way, the second component is disposed in a large quantity of manners, and is applicable to a large quantity of scenarios.

In a possible implementation, respective first sub-conductive layers of the first conductive layer and the second conductive layer are all located in the first region, and respective second sub-conductive layers of the first conductive layer and the second conductive layer are all located in the first region and the second region.

In this way, the second sub-conductive layer has the relatively small thickness, the manufacturing time of the second sub-conductive layer is short, and a process is simple. Therefore, manufacturing the second sub-conductive layers simultaneously in the first region and the second region has small impact on manufacturing time and difficulty of the conductive layer. The first sub-conductive layer is not disposed in the second region, so that manufacturing time of the first sub-conductive layer can be shortened, and manufacturing difficulty of the first sub-conductive layer can be reduced. This is conducive to reducing costs.

In a possible implementation, a first sub-conductive layer and a second sub-conductive layer of the third conductive layer are located in the first region and the second region.

In this way, the first sub-conductive layer and the second sub-conductive layer of the third conductive layer are disposed in both the first region and the second region, so that flatness of each sub-insulation layer can be improved. This reduces difficulty in connecting the conductive layer or the component at each sub-insulation layer.

In a possible implementation, the power module includes a heat dissipation member, the heat dissipation member is disposed on a side that is of the first conductive layer and the second conductive layer and that faces away from the insulation layer, and the heat dissipation member is located in the first region.

In this way, heat dissipation efficiency of the power module can be improved.

In a possible implementation, the power module includes a thermally conductive insulation layer, the thermally conductive insulation layer is disposed on a side that is of the heat dissipation member and that faces the insulation layer, and the thermally conductive insulation layer is located in the first region.

In this way, the thermally conductive insulation layer can effectively electrically isolate the first conductive layer from another external mechanical member (for example, a circuit board), so that when the power module is installed on the circuit board, insulation processing does not need to be performed between the circuit board and the first conductive layer. This can simplify an installation process between the power module and the circuit board. The thermally conductive insulation layer may further transfer heat of the first conductive layer to the heat dissipation member, to effectively implement heat dissipation.

In a possible implementation, the power module includes a conductive pillar, the sub-insulation layer has a third accommodation cavity, the conductive pillar is located in the third accommodation cavity, and two conductive layers adjacent to the sub-insulation layer at which the conductive pillar is disposed are electrically connected to the conductive pillar.

In this way, the two adjacent conductive layers are electrically connected through the conductive pillar, so that signal transmission between the two adjacent conductive layers can be implemented. If a material of the conductive pillar is a metal material, thermal conductivity of the conductive pillar is better than thermal conductivity of the insulation layer, so that the heat dissipation efficiency of the power module can be effectively improved.

A second aspect of embodiments of this application provides a power conversion device, including a circuit board and a plurality of power modules in the first aspect. The plurality of power modules are all disposed on the circuit board.

According to the power conversion device provided in embodiments of this application, the power conversion device may include the power module. The power module may include: the insulation layer, the plurality of conductive layers, the decoupling capacitor, and the plurality of first components. The insulation layer includes the plurality of sub-insulation layers stacked in the thickness direction of the power module, and the sub-insulation layer is disposed between every two adjacent conductive layers. The sub-insulation layer may be configured to electrically isolate two adjacent conductive layers. The power module may include the first region, the sub-insulation layer located in the first region has the first accommodation cavity, the first component may be located in the first accommodation cavity, and the conductive layer adjacent to the sub-insulation layer at which the first component is disposed is electrically connected to the first component. The first component may be electrically connected to another component of the power module and/or an external circuit through the conductive layer, so that connection through wire bonding is avoided. Both the parasitic inductance and the parasitic resistance of the conductive layer are small, and the voltage (current) change rate is reduced. This alleviates the voltage oscillation phenomenon, further alleviates the voltage spike caused to the first component, reduces the voltage stress on the first component, and improves the response speed and the efficiency of the first component. In this way, costs are reduced, phenomena such as electrical breakdown and thermal damage of the first component are reduced, and the first component is protected. The at least some of the first components may be stacked in the thickness direction of the power module, so that the space of the insulation layer in the thickness direction can be fully used, to reduce the plane size of the plurality of first components, reduce the planar area that is of the insulation layer and that is occupied by the plurality of first components, and improve the integration of the power module. This improves performance of the power module and reduces manufacturing costs of the power module. In addition, reducing the connection areas between the plurality of first components and the insulation layer may further improve the stress and the deformation that are generated between the plurality of first components and the insulation layer, to reduce the possibility of stripping the first component from the insulation layer. The insulation layer located in the first region may have the auxiliary accommodation cavity, the decoupling capacitor may be located in the auxiliary accommodation cavity, the first pin of the decoupling capacitor may be electrically connected to one layer of the plurality of conductive layers, and the second pin of the decoupling capacitor may be electrically connected to another layer of the plurality of conductive layers. The decoupling capacitor is electrically connected to the at least one of the plurality of first components through the conductive layer, and the decoupling capacitor may absorb the voltage spike. This reduces the voltage stress and protects the electrically connected first component.

A third aspect of embodiments of this application provides a vehicle, including a housing and the power conversion device in the second aspect. The power conversion device is located in the housing.

According to the vehicle provided in embodiments of this application, the vehicle may include the power conversion device. The power conversion device may include the power module. The power module may include: the insulation layer, the plurality of conductive layers, the decoupling capacitor, and the plurality of first components. The insulation layer includes the plurality of sub-insulation layers stacked in the thickness direction of the power module, and the sub-insulation layer is disposed between every two adjacent conductive layers. The sub-insulation layer may be configured to electrically isolate two adjacent conductive layers. The power module may include the first region, the sub-insulation layer located in the first region has the first accommodation cavity, the first component may be located in the first accommodation cavity, and the conductive layer adjacent to the sub-insulation layer at which the first component is disposed is electrically connected to the first component. The first component may be electrically connected to another component of the power module and/or an external circuit through the conductive layer, so that connection through wire bonding is avoided. Both the parasitic inductance and the parasitic resistance of the conductive layer are small, and the voltage (current) change rate is reduced. This alleviates the voltage oscillation phenomenon, further alleviates the voltage spike caused to the first component, reduces the voltage stress on the first component, and improves the response speed and the efficiency of the first component. In this way, costs are reduced, phenomena such as electrical breakdown and thermal damage of the first component are reduced, and the first component is protected. The at least some of the first components may be stacked in the thickness direction of the power module, so that the space of the insulation layer in the thickness direction can be fully used, to reduce the plane size of the plurality of first components, reduce the planar area that is of the insulation layer and that is occupied by the plurality of first components, and improve the integration of the power module. This improves performance of the power module and reduces manufacturing costs of the power module. In addition, reducing the connection areas between the plurality of first components and the insulation layer may further improve the stress and the deformation that are generated between the plurality of first components and the insulation layer, to reduce the possibility of stripping the first component from the insulation layer. The insulation layer located in the first region may have the auxiliary accommodation cavity, the decoupling capacitor may be located in the auxiliary accommodation cavity, the first pin of the decoupling capacitor may be electrically connected to one layer of the plurality of conductive layers, and the second pin of the decoupling capacitor may be electrically connected to another layer of the plurality of conductive layers. The decoupling capacitor is electrically connected to the at least one of the plurality of first components through the conductive layer, and the decoupling capacitor may absorb the voltage spike. This reduces the voltage stress and protects the electrically connected first component.

A structure of this application and other objectives and beneficial effect thereof will be more obvious and easier to understand through descriptions of embodiments with reference to accompanying drawings.

### BRIEF DESCRIPTION OF DRAWINGS

FIG. 1 is a schematic diagram of a structure of a power module according to an embodiment of this application;
FIG. 2 is a schematic diagram of another structure of a power module according to an embodiment of this application;
FIG. 3 is a schematic diagram of a partial enlarged structure of FIG. 1;
FIG. 4 is a diagram of an equivalent circuit of a half-bridge circuit including a first transistor and a second transistor according to an embodiment of this application;
FIG. 5 is a schematic diagram of a structure of two adjacent sub-conductive layers of a conductive layer according to an embodiment of this application; and
FIG. 6 is a schematic diagram of another structure of two adjacent sub-conductive layers of a conductive layer according to an embodiment of this application.

### Reference numerals:

100: power module; 100a: first region; 100b: second region;
101: insulation layer; 101a: first side; 101b: second side;
110: sub-insulation layer; 111: first sub-insulation layer; 112: second sub-insulation layer;
120: conductive layer; 121: first conductive layer; 122: second conductive layer;
123: third conductive layer; 130: sub-conductive layer; 131: first sub-conductive layer;
132: second sub-conductive layer; 133: third sub-conductive layer; 141: first connection portion;
142: second connection portion; 150: decoupling capacitor; 151: first pin;
152: second pin; 161: first accommodation cavity; 162: second accommodation cavity;
163: third accommodation cavity; 164: auxiliary accommodation cavity; 170: first component group;
171: first component; 171a: first transistor; 171b: second transistor;
172: second component; 181: insulation fastener; 182: conductive hole;
183: conductive pillar; 184: thermally conductive insulation layer; 185: heat dissipation member;
186: packaging member.

### DESCRIPTION OF EMBODIMENTS

Terms used in implementations of this application are merely used to explain specific embodiments of this application, but are not intended to limit this application.

In a related technology, a power module may include a circuit board and a plurality of chips integrated on a surface of the circuit board. The chips are parallel to the circuit board, and are disposed at spacings along an extension direction of the circuit board. This is equivalent to that the chips are tiled on the surface of the circuit board along a plane on which the circuit board is located. A first pad may be disposed on each chip, and a second pad may be disposed on the circuit board. The first pad of each chip may be electrically connected to the second pad of the circuit board in a wire bonding manner, to implement signal transmission between the circuit board and the chip.

However, because the chips are parallel to the circuit board and are disposed at spacings along the extension direction of the circuit board, a planar area that is of the circuit board and that is occupied by the plurality of chips is large. Consequently, integration of the power module is reduced, and performance of the power module is affected. As a result, manufacturing costs of the power module is high.

In addition, due to different thermal expansion coefficients of the chip and the circuit board, the chip and the circuit board are different in thermal expansion or cold contraction, so that stress and deformation are generated between the chip and the circuit board. If a connection area between each tiled chip and the circuit board is large, the stress and the deformation that are generated between the chip and the circuit board are further increased. Consequently, the chip and the circuit board are easily separated from each other and fail.

Second, a lead has a small diameter and a large length, and generates a large parasitic inductance and a large parasitic resistance during operation, which easily causes an increase in a voltage (current) change rate, and causes severe voltage oscillation, thereby causing a large voltage spike to the chip. The voltage spike causes large voltage stress to the chip and reduces a response speed of the chip. Consequently, the power module has lower efficiency, costs are higher (for example, the chip is derated and used), and even phenomena such as electrical breakdown and thermal damage of the chip are caused.

Based on the foregoing problem, embodiments of this application provide a power module, a power conversion device, and a vehicle. The power module may include an insulation layer, a plurality of conductive layers, a decoupling capacitor, and a plurality of first components. The insulation layer includes a plurality of sub-insulation layers stacked in a thickness direction of the power module, and the sub-insulation layer is disposed between every two adjacent conductive layers. The sub-insulation layer may be configured to electrically isolate two adjacent conductive layers. The power module may include a first region, a sub-insulation layer located in the first region has a first accommodation cavity, the first component may be located in the first accommodation cavity, and the conductive layer adjacent to the sub-insulation layer at which the first component is disposed is electrically connected to the first component. The first component may be electrically connected to another component of the power module and/or an external circuit through the conductive layer, so that connection through wire bonding is avoided. Both a parasitic inductance and a parasitic resistance of the conductive layer are small, and a voltage (current) change rate is reduced. This alleviates a voltage oscillation phenomenon, further alleviates a voltage spike caused to the first component, reduces voltage stress on the first component, and improves a response speed and efficiency of the first component. In this way, costs are reduced, phenomena such as electrical breakdown and thermal damage of the first component are reduced, and the first component is protected.

At least some of the first components may be stacked in the thickness direction of the power module, so that space of the insulation layer in the thickness direction can be fully used, to reduce a plane size of the plurality of first components, reduce a planar area that is of the insulation layer and that is occupied by the plurality of first components, and improve integration of the power module. This improves performance of the power module, the power conversion device, and the vehicle, and reduces manufacturing costs of the power module. In addition, reducing connection areas between the plurality of first components and the insulation layer may further improve stress and deformation that are generated between the plurality of first components and the insulation layer, to reduce a possibility of stripping the first component from the insulation layer.

The insulation layer located in the first region may have an auxiliary accommodation cavity, the decoupling capacitor may be located in the auxiliary accommodation cavity, a first pin of the decoupling capacitor may be electrically connected to one layer of the plurality of conductive layers, and a second pin of the decoupling capacitor may be electrically connected to another layer of the plurality of conductive layers. The decoupling capacitor is electrically connected to at least one of the plurality of first components through the conductive layer, and the decoupling capacitor may absorb the voltage spike. This reduces the voltage stress and protects the electrically connected first component.

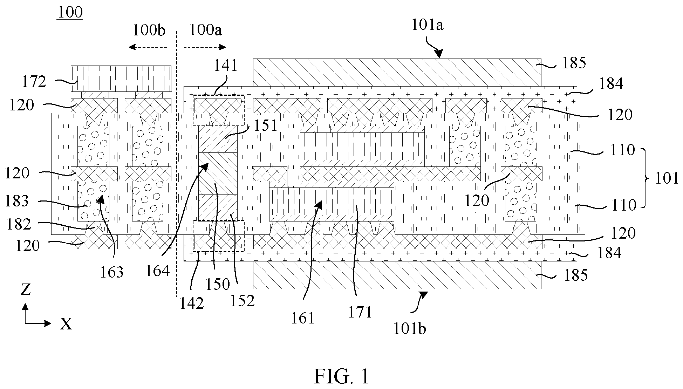

The following describes the vehicle provided in embodiments of this application with reference to FIG. 1 to FIG. 6.

The vehicle provided in embodiments may include but is not limited to an electric vehicle (EV), a hybrid electric vehicle (HEV), a range extended electric vehicle (REEV), a plug-in hybrid electric vehicle (PHEV), a fuel cell vehicle, and the like.

An electric vehicle is used as an example for description in embodiments of this application.

The vehicle may include a housing, the housing is an outer envelope of the vehicle, and the housing may protect the vehicle. The vehicle may include a steering wheel, and a driver may control a driving direction of the vehicle by using the steering wheel. The vehicle may include an engine, a brake, a throttle, wheels, and the like, to implement normal driving of the vehicle.

The vehicle may include a battery and a power conversion device that are located in the housing. The battery may be electrically connected to the engine through the power conversion device, and the battery may provide electric energy for the engine of the vehicle. The engine converts the electric energy into mechanical energy to provide kinetic energy for the vehicle to drive the wheels to move, so that the vehicle can run normally.

The following describes the power conversion device provided in embodiments of this application.

The power conversion device may include but is not limited to an inverter (for example, a photovoltaic inverter), a direct-current combiner box, an alternating-current combiner box, a direct current (DC)/direct current converter, a direct current/alternating current converter, and the like.

It may be understood that, the power conversion device provided in embodiments of this application may be used in a new energy vehicle, and may also be applied to a field of new energy power generation (for example, photovoltaic power generation, wind power generation, or energy storage), chargers, charging piles, variable-frequency home appliances, communication devices (for example, servers, base stations, switches), or the like.

The power conversion device may include a power module 100. There may be a plurality of power modules 100. The plurality of power modules 100 may be electrically connected. For example, the plurality of power modules 100 may be connected in parallel. The power conversion device may include a circuit board, and the plurality of power modules 100 may all be located on the circuit board. An external circuit electrically connected to the plurality of power modules 100 may be further disposed on the circuit board. For example, the external circuit may include an inductive element, and the power module 100 may include a half-bridge circuit (the half-bridge circuit is described in a subsequent embodiment).

The power module 100 may be a component that requires a high frequency, a high power, and intelligent control, such as a power supply power module, a radio frequency module, a power amplifier module, an artificial intelligence (AI) module, a central processing unit (CPU) module, or a graphics processing unit (GPU) module.

The following describes the power module 100 provided in embodiments of this application.

Refer to FIG. 1. An embodiment of this application provides a power module 100. The power module 100 may include an insulation layer 101 and a plurality of conductive layers 120. The insulation layer 101 may be used as a bearing part of the power module 100, and is configured to bear various components in the power module 100.

Refer to FIG. 1. The power module 100 may include a first direction X, a second direction, and a third direction Z. The first direction X, the second direction, and the third direction Z may all be different. The first direction X and the second direction may be any two different directions parallel to the insulation layer 101, and the third direction Z may be any direction that intersects with the insulation layer 101. For example, every two of the first direction X, the second direction, and the third direction Z may be perpendicular to each other. For example, the first direction X may be a length direction of the power module 100, the second direction may be a width direction of the power module 100, and the third direction Z may be a thickness direction of the power module 100. A length, a width, a thickness, and the like in embodiments of this application are merely for ease of description, and do not mean any limitation on a size. For example, the width may be greater than, equal to, or less than the length.

In the thickness direction (the third direction Z) of the power module 100, the insulation layer 101 may include a plurality of stacked sub-insulation layers 110. The sub-insulation layer 110 may be disposed between every two adjacent conductive layers 120, and every two adjacent conductive layers 120 are electrically isolated by using the sub-insulation layer 110. For example, a quantity of sub-insulation layers 110 may be any quantity such as two, three, four, five, or more.

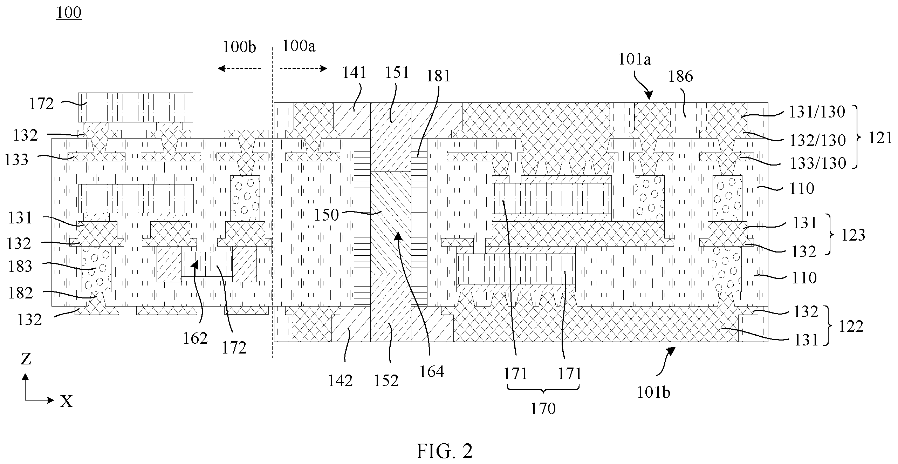

Refer to FIG. 1 and FIG. 2. In the thickness direction (the third direction Z) of the power module 100, the insulation layer 101 may include a first side 101a and a second side 101b that are disposed opposite to each other. The plurality of conductive layers 120 may include a first conductive layer 121, a second conductive layer 122, and at least one third conductive layer 123. The first conductive layer 121 may be located on the first side 101a, the second conductive layer 122 may be located on the second side 101b, and the third conductive layer 123 may be located between the first conductive layer 121 and the second conductive layer 122. A quantity of third conductive layers 123 may be any quantity such as one, two, three, four, or more.

In some embodiments, refer to FIG. 1 and FIG. 2. The power module 100 may include a first region 100a. The insulation layer 101 in the first region 100a may be configured to bear a first component 171. There may be at least one first component 171. For example, there may be a plurality of first components 171. In some examples, the plurality of first components 171 may be located on a surface of the insulation layer 101. For example, the first component 171 may be located on a side that is of the first conductive layer 121 and that faces away from the second conductive layer 122, and the first component 171 may be electrically connected to another component of the power module 100 and/or an external circuit through the first conductive layer 121; and/or the first component 171 may be located on a side that is of the second conductive layer 122 and that faces away from the first conductive layer 121, and the first component 171 may be electrically connected to another component of the power module 100 and/or an external circuit through the second conductive layer 122. This is equivalent to that the first component 171 may be located on a side that is of at least one of the first conductive layer 121 and the second conductive layer 122 and that faces away from the insulation layer 101. Through this disposing, the first component 171 may be located on a surface on at least one side of the insulation layer 101 in the thickness direction, which helps simplify debugging and installation of the first component 171. In some other examples, the plurality of first components 171 may be embedded in the insulation layer 101, a first accommodation cavity 161 may be provided at the insulation layer 101 located in the first region 100a, and the first component 171 may be located in the first accommodation cavity 161, so that the first component 171 can be well protected. In some other examples, some of the first components 171 may be located on a surface of the insulation layer 101, and the other part of the first components 171 may be embedded in the insulation layer 101. A principle thereof has been described. Details are not described again. In embodiments of this application, an example in which the first component 171 is embedded in the insulation layer 101 is used for description.

In some embodiments, refer to FIG. 1 and FIG. 2. The power module 100 may include a second region 100b. The insulation layer 101 in the second region 100b may be configured to bear a second component 172. There may be at least one second component 172. For example, there may be a plurality of second components 172. In some examples, the plurality of second components 172 may be located on the surface of the insulation layer 101. For example, the second component 172 may be located on a side that is of at least one of the first conductive layer 121 and the second conductive layer 122 and that faces away from the insulation layer 101. Through this disposing, the second component 172 may be located on a surface on at least one side of the insulation layer 101 in the thickness direction (for example, may be welded on a surface of the first conductive layer 121 and/or a surface of the second conductive layer 122), which helps simplify debugging and installation of the second component 172. For example, the second component 172 may include a control chip and/or a drive chip. The control chip or the drive chip or both have a large quantity of pins. Therefore, connection between the control chip and/or the drive chip and the conductive layer 120 is complex. When the control chip or the drive chip or both are disposed on a surface, installation difficulty and debugging difficulty of the control chip and/or the drive chip can be effectively reduced. In some other examples, the plurality of second components 172 may be located inside the insulation layer 101 (which is equivalent to being embedded in the insulation layer 101), a second accommodation cavity 162 may be provided at the insulation layer 101 located in the second region 100b, and the second component 172 may be located in the second accommodation cavity 162, so that the second component 172 can be well protected. In some other examples, some of the second components 172 may be located on the surface of the insulation layer 101, and the other part of the second components 172 may be located inside the insulation layer 101. A principle thereof has been described. Details are not described again.

The second region 100b may be located on a part or all of a periphery of the first region 100a. For example, the second region 100b may be located on at least one side of the first region 100a. For example, the second region 100b may be located on at least one side of the first region 100a in the first direction X, and/or the second region 100b may be located on at least one side of the first region 100a in the second direction. The first region 100a and the second region 100b may be disposed adjacent to each other, so that a distance between the first region 100a and the second region 100b is short, to reduce a signal transmission path between the first region 100a and the second region 100b. This helps reduce an area of the power module 100. Alternatively, a third region may be disposed between the first region 100a and the second region 100b, and the first region 100a and the second region 100b are connected through the third region. A location relationship between the first region 100a and the second region 100b is not limited in embodiments of this application.

It may be understood that, the power module 100 in embodiments of this application may include either the first region 100a or the second region 100b, or may include both the first region 100a and the second region 100b. In embodiments of this application, an example in which both the first region 100a and the second region 100b are disposed is used for description.

In some embodiments, a sum of powers of all the first components 171 may be greater than a sum of powers of all the second components 172. In this case, a sum of heat generated by all the first components 171 may be greater than a sum of heat generated by all the second components 172.

For example, the first region 100a may be a power region, and the first component 171 may include a power semiconductor component (which may be, for example, a power chip). The power semiconductor component is a core of electric energy conversion and circuit control in the power conversion device, and may have a characteristic of unidirectional conductivity of a semiconductor. The power semiconductor component may include a diode, a thyristor, a transistor, and the like. The transistor may include an insulated gate bipolar transistor (IGBT) and a field effect transistor (FET), for example, a metal-oxide semiconductor field effect transistor (MOSFET). The diode may include a fast recovery diode (FRD). The FRD has advantages such as good conduction/disconnection and short reverse recovery time.

For example, the second region 100b may be a control region, the second component 172 may include a control component (for example, a control chip) and/or a drive component (for example, a drive chip), and the second component 172 may include a passive component, for example, a capacitor, an inductor, a resistor, or a sensor. The plurality of second components 172 in the second region 100b may jointly form a drive circuit, to drive turning on/off of each first component 171 in the first region 100a and perform a related sensing control function, to implement control and protection functions on the power module 100, and improve availability and reliability of the power module 100. The second component 172 may be electrically connected to the first component 171 through the conductive layer 120, so that connection through wire bonding is avoided. The conductive layer 120 shortens a drive path and reduces a parasitic inductance and a parasitic resistance, to reduce a voltage (current) change rate. This alleviates a voltage oscillation phenomenon, further alleviates a voltage spike caused to the first component 171, reduces voltage stress on the first component 171, and improves a response speed and efficiency of the first component 171. In this way, costs are reduced, and phenomena such as electrical breakdown and thermal damage of the first component 171 are reduced.

In an implementation in which both the control region and the power region are disposed in the power module 100, compared with a related technology in which the control region and the power region are separately disposed as two modules, in embodiments of this application, the power region and the control region are integrated into the same power module 100, so that a total planar area of the power region and the control region can be reduced, and integration of the power module 100 can be improved. The power region and the control region are formed in the power module 100, so that functions of the power module 100 can also be enriched, to implement an intelligent module.

The following describes the power module 100 in the first region 100a provided in embodiments of this application.

Refer to FIG. 1 and FIG. 2. A sub-insulation layer 110 located in the first region 100a may have the first accommodation cavity 161, the first component 171 may be located in the first accommodation cavity 161, and at least some of the first components 171 may be stacked in the thickness direction (the third direction Z) of the power module 100. Through this disposing, space of the insulation layer 101 in the thickness direction can be fully used, to reduce a plane size of the plurality of first components 171, reduce a planar area that is of the insulation layer 101 and that is occupied by the plurality of first components 171. and improve the integration of the power module 100. This improves performance of the power module 100 and reduces manufacturing costs of the power module 100. In addition, stress and deformation that are generated between the plurality of first components 171 and the insulation layer 101 may be further improved, to reduce a possibility of stripping the first component 171 from the insulation layer 101.

Some of the first components 171 may be stacked in the thickness direction of the power module 100. In this way, on a premise that the integration of the power module 100 is improved and the possibility of stripping the first component 171 from the insulation layer 101 is reduced, large pressure that is on a first component 171 located at a bottom and that is generated due to excessive stacked first components 171 is avoided. Alternatively, all of the first components 171 may be stacked in the thickness direction of the power module 100. In this way, the integration of the power module 100 can be better improved, and the possibility of stripping the first component 171 from the insulation layer 101 can be reduced.

One first accommodation cavity 161 may be located in one sub-insulation layer 110. Alternatively, one first accommodation cavity 161 may be located in a plurality of adjacent sub-insulation layers 110, and the first accommodation cavity 161 may penetrate, in the thickness direction, a conductive layer 120 located in the plurality of adjacent sub-insulation layers 110, so that a volume of the first accommodation cavity 161 may be increased to accommodate thicker and more first components 171. At least one first component 171 may be accommodated in one first accommodation cavity 161. If there are a plurality of first components 171 in one first accommodation cavity 161, the plurality of first components 171 may be stacked in the same first accommodation cavity 161 in the thickness direction, or may be tiled in the same first accommodation cavity 161 along a plane on which the insulation layer 101 is located. At least one of the conductive layers 120 adjacent to the sub-insulation layer 110 at which the first component 171 is disposed may be electrically connected to the first component 171. The first component 171 may be electrically connected to another component of the power module 100 and/or an external circuit through the adjacent conductive layer 120, so that connection through wire bonding is avoided. Both the parasitic inductance and the parasitic resistance of the conductive layer 120 are small, and the voltage (current) change rate can be reduced. This alleviates the voltage oscillation phenomenon, further alleviates the voltage spike caused to the first component 171, reduces the voltage stress on the first component 171, and improves the response speed and the efficiency of the first component 171. In this way, costs are reduced, and phenomena such as electrical breakdown and thermal damage of the first component 171 are reduced.

For example, refer to FIG. 2. The plurality of first components 171 stacked in the thickness direction of the power module 100 may form a first component group 170, and there may be at least one first component group 170. If there are a plurality of first component groups 170, the plurality of first component groups 170 may be arranged along the plane on which the insulation layer 101 is located (for example, arranged along the first direction X). FIG. 2 shows only one first component group 170.

In a same first component group 170, a quantity of first components 171 may be any quantity such as two, three, four, five, or more. The plurality of first components 171 in the same first component group 170 may be electrically connected, or may not be electrically connected. Quantities of first components 171 in any two first component groups 170 may be the same or different. Any two first component groups 170 may be electrically connected, or may not be electrically connected. At least some of first components 171 of any two first component groups 170 may be located in a same sub-insulation layer 110, or all of first components 171 of any two first component groups 170 may be located at different sub-insulation layers 110.

The following describes the same first component group 170 provided in embodiments of this application.

Refer to FIG. 1 and FIG. 2. One first accommodation cavity 161 may be located in one sub-insulation layer 110, and conductive layers 120 are disposed adjacent to each other on two sides of each sub-insulation layer 110 in the thickness direction. A first component 171 located at the sub-insulation layer 110 may be electrically connected to another component of the power module 100 and/or an external circuit through at least one of the two adjacent conductive layers 120. In the thickness direction of the power module 100, one third conductive layer 123 may be disposed between two adjacent first components 171, and the two adjacent first components 171 may be electrically connected through the third conductive layer 123. In addition, a first component 171 closest to the first side 101a may be electrically connected to the first conductive layer 121, and/or a first component 171 closest to the second side 101b may be electrically connected to the second conductive layer 122. Through this disposing, the first component 171 is electrically connected to another component and/or an external circuit through the conductive layer 120, so that the voltage stress on the first component 171 can be reduced, and the response speed and the efficiency of the first component 171 can be improved. In this way, costs are reduced, and phenomena such as electrical breakdown and thermal damage of the first component 171 are reduced. A principle thereof has been described. Details are not described again.

The following describes an example in which the first component 171 provided in embodiments of this application is a transistor.

The transistor may include a first electrode, a second electrode, and a control electrode. One of the first electrode and the second electrode may be a source of the transistor, the other one of the first electrode and the second electrode may be a drain of the transistor, and the control electrode may be a gate of the transistor. A voltage between the drain and the source and a voltage between the gate and the source are controlled, so that electrons can form a "channel" in the transistor, to implement conduction of the transistor. In addition, a value of the voltage is adjusted, so that a value of a conduction current can be controlled, and finally switching between "on" and "off" is implemented. For example, the first electrode and the control electrode may be disposed on a side that is of the transistor and that faces the first side 101a, and the second electrode may be disposed on a side that is of the transistor and that faces the second side 101b. An orientation of the transistor in the thickness direction may be interchanged.

For example, in a same first component group 170, there are a plurality of first components 171. This is equivalent to that there may be a plurality of transistors. In two adjacent transistors, a second electrode of a transistor close to the first side 101a and a first electrode of a transistor close to the second side 101b are electrically connected through a third conductive layer 123 between the two adjacent transistors, and a control electrode of the transistor close to the second side 101b is electrically connected to the second component 172 in the second region 100b through the third conductive layer 123 between the two adjacent transistors. In addition, both a control electrode and a first electrode of a transistor closest to the first side 101a are electrically connected to the first conductive layer 121, the control electrode of the transistor closest to the first side 101a is electrically connected to the second component 172 in the second region 100b through the first conductive layer 121, and the first electrode of the transistor closest to the first side 101a is electrically connected to another component (for example, a first pin 151 of a decoupling capacitor 150) of the power module 100 and/or an external circuit through the first conductive layer 121. A second electrode of a transistor closest to the second side 101b is electrically connected to the second conductive layer 122, and may be electrically connected to another component (for example, a second pin 152 of the decoupling capacitor 150) of the power module 100 and/or an external circuit through the second conductive layer 122.

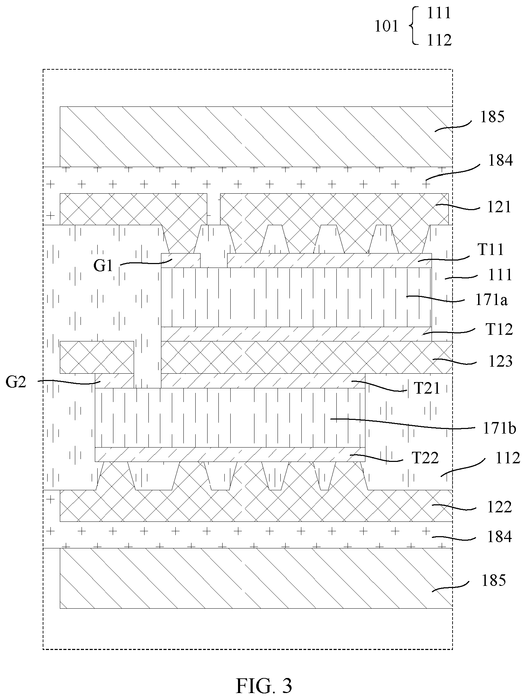

For example, refer to FIG. 3. In a same first component group 170, there may be two transistors. There may be one third conductive layer 123, and the third conductive layer 123 may be located between the two transistors. The plurality of sub-insulation layers 110 may include a first sub-insulation layer 111 and a second sub-insulation layer 112. The first sub-insulation layer 111 may be located between the first conductive layer 121 and the third conductive layer 123, and the second sub-insulation layer 112 may be located between the second conductive layer 122 and the third conductive layer 123. The two transistors may include a first transistor 171a and a second transistor 171b. The first transistor 171a may be located in the first sub-insulation layer 111, and the second transistor 171b may be located in the second sub-insulation layer 112. A first electrode T11 and a control electrode G1 of the first transistor 171a may be electrically connected to the first conductive layer 121. A second electrode T12 of the first transistor 171a and a first electrode T21 of the second transistor 171b may be electrically connected through the third conductive layer 123. A control electrode G2 of the second transistor 171b may be electrically connected to the third conductive layer 123. A second electrode T22 of the second transistor 171b may be electrically connected to the second conductive layer 122. In this case, the first transistor 171a is a transistor closest to the first side 101a in the first component group 170, the second transistor 171b is a transistor closest to the second side 101b in the first component group 170, and the first transistor 171a and the second transistor 171b are two adjacent transistors. In this case, because a quantity of transistors in the same first component group 170 is small, manufacturing difficulty of the first component group 170 may be reduced. In an implementation in which there are a plurality of first component groups 170, first transistors 171a of the plurality of first component groups 170 may be all located in a first sub-insulation layer 111, and second transistors 171b of the plurality of first component groups 170 may be all located in a second sub-insulation layer 112. One first transistor 171a and one second transistor 171b are disposed correspondingly, and form one first component group 170.

It may be understood that, there may be a pattern at the conductive layer 120, and there are a plurality of wirings in the pattern. At least a part of the plurality of wirings may be insulated from each other, or at least a part of the plurality of wirings may be electrically connected to each other. For example, that the first electrode T11 and the control electrode G1 of the first transistor 171a are electrically connected to the first conductive layer 121 means that the first electrode T11 and the control electrode G1 of the first transistor 171a are respectively electrically connected to different wirings that are insulated from each other at the first conductive layer 121.

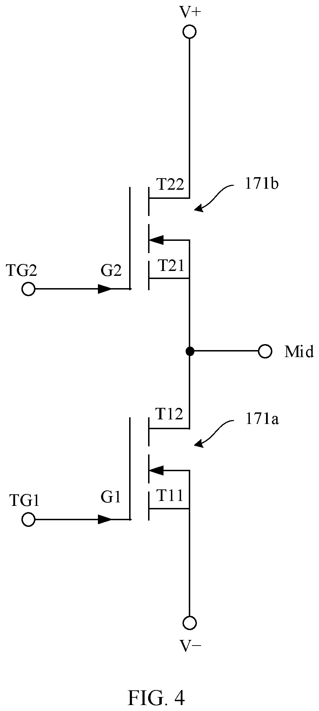

Refer to FIG. 3 and FIG. 4. The first transistor 171a and the second transistor 171b may be configured to form the half-bridge circuit. The second component 172 located in the second region 100b may provide a drive/control signal TG1 for the control electrode G1 of the first transistor 171a by using the first conductive layer 121. The first electrode T11 of the first transistor 171a may be electrically connected to a first power signal V- of an external circuit through the first conductive layer 121. The half bridge circuit may output a signal Mid to the external circuit by using the third conductive layer 123. The second component 172 located in the second region 100b may provide a drive/control signal TG2 for the control electrode G2 of the second transistor 171b by using the third conductive layer 123. The second electrode T22 of the second transistor 171b may be electrically connected to a second power signal V+ of the external circuit through the second conductive layer 122.

The following describes the decoupling capacitor 150 provided in embodiments of this application.

The decoupling capacitor 150 may be electrically connected to at least one of the plurality of first components 171 (parallel connection is used as an example in embodiments of this application) through the conductive layer 120. The decoupling capacitor 150 may absorb the voltage spike, to reduce the voltage stress and protect the first component 171. In addition, a lead may be avoided, so that the voltage stress on the first component 171 can be reduced, and the response speed and the efficiency of the first component 171 can be improved. In this way, costs are reduced, and phenomena such as electrical breakdown and thermal damage of the first component 171 are reduced. The decoupling capacitor 150 may be located in the first region 100a, so that the decoupling capacitor 150 is close to the first component 171, to shorten a transmission distance between the decoupling capacitor 150 and the first component 171. Certainly, the decoupling capacitor 150 may alternatively be located in the second region 100b. In embodiments of this application, an example in which the decoupling capacitor 150 is located in the first region 100a is used for description. There may be at least one decoupling capacitor 150. For example, a quantity of decoupling capacitors 150 may be any quantity such as one, two, three, four, or more.

For example, refer to FIG. 1 and FIG. 2. The insulation layer 101 located in the first region 100a may have an auxiliary accommodation cavity 164, and the decoupling capacitor 150 may be located in the auxiliary accommodation cavity 164. The first pin 151 of the decoupling capacitor 150 may be electrically connected to one layer of the plurality of conductive layers 120, and the second pin 152 of the decoupling capacitor 150 may be electrically connected to another layer of the plurality of conductive layers 120, so that the decoupling capacitor 150 may be connected in parallel to at least one of the plurality of first components 171. One of the first pin 151 and the second pin 152 of the decoupling capacitor 150 may be a positive electrode, and the other one of the first pin 151 and the second pin 152 of the decoupling capacitor 150 may be a negative electrode. The decoupling capacitor 150 may protect only some of the first components 171, or may protect all of the first components 171. In embodiments of this application, an example in which the decoupling capacitor 150 protects all of the first components 171 is used for description.

In a process of assembling the decoupling capacitor 150, after the auxiliary accommodation cavity 164 is formed in the insulation layer 101, the decoupling capacitor 150 may be placed in the auxiliary accommodation cavity 164. For example, refer to FIG. 2. There may be a gap between the decoupling capacitor 150 and a cavity wall of the auxiliary accommodation cavity 164, so that assemblability of the decoupling capacitor 150 can be improved, and assembly difficulty can be reduced. An insulation fastener 181 may be disposed between the decoupling capacitor 150 and the cavity wall of the auxiliary accommodation cavity 164. The insulation fastener 181 may be configured to fill the gap between the decoupling capacitor 150 and the cavity wall of the auxiliary accommodation cavity 164, so that the decoupling capacitor 150 is better fastened in the auxiliary accommodation cavity 164. This avoids a case such as a misplacement of the decoupling capacitor 150 in a subsequent process of connecting the decoupling capacitor 150 to the conductive layer 120, and reduces assembly difficulty.

For example, one auxiliary accommodation cavity 164 may be located in one sub-insulation layer 110. Alternatively, one auxiliary accommodation cavity 164 may be located in a plurality of adjacent sub-insulation layers 110, and the auxiliary accommodation cavity 164 may penetrate, in the thickness direction, a conductive layer 120 located in the plurality of adjacent sub-insulation layers 110. One decoupling capacitor 150 or a plurality of decoupling capacitors 150 may be disposed in one auxiliary accommodation cavity 164. A principle thereof is similar to that of the first accommodation cavity 161 and the first component 171. Details are not described again. A manner of disposing another accommodation cavity and a component located in the accommodation cavity provided in embodiments of this application is similar to a manner of disposing the first accommodation cavity 161 and the first component 171. Details are not described again.

One decoupling capacitor 150 may be connected in parallel to at least one first component 171. For example, one decoupling capacitor 150 may be connected in parallel to one, two, three, or four or more first components 171. It may be understood that, the decoupling capacitor 150 may include a plurality of sub-decoupling capacitors connected in parallel, so that a capacity of the decoupling capacitor 150 can be increased, capacitance can be reduced, and a service life of the decoupling capacitor 150 can be prolonged. If one decoupling capacitor 150 is connected in parallel to all of the first components 171, the decoupling capacitor 150 protects a large quantity of first components 171. In addition, there is a small quantity of decoupling capacitors 150, and connection between the decoupling capacitor 150 and the first component 171 is simple, so that a manufacturing process can be simplified.

In an implementation in which a same first component group 170 includes a plurality of transistors stacked in the thickness direction, a first electrode of a transistor closest to the first side 101a may be electrically connected to the first pin 151 of the decoupling capacitor 150 through the first conductive layer 121. A second electrode of a transistor closest to the second side 101b may be electrically connected to the second pin 152 of the decoupling capacitor 150 through the second conductive layer 122. Refer to FIG. 3. In an implementation in which the same first component group 170 includes the first transistor 171a and the second transistor 171b, the first pin 151 of the decoupling capacitor 150 may be electrically connected to the first electrode T11 of the first transistor 171a through the first conductive layer 121, and the second pin 152 of the decoupling capacitor 150 may be electrically connected to the second electrode T22 of the second transistor 171b through the second conductive layer 122, to connect the decoupling capacitor 150 in parallel to the first transistor 171a and the second transistor 171b. This is equivalent to that the two transistors may be configured to form the half-bridge circuit, the decoupling capacitor 150 may be connected in parallel to the two transistors of the half-bridge circuit, and the vertically inserted decoupling capacitor 150 may absorb a voltage spike of the half-bridge circuit. This reduces voltage stress of the two transistors of the half-bridge circuit and protects the two transistors. In addition, the power module 100 provided in embodiments of this application may alternatively be applied to a high-voltage and high-current power module 100 scenario.

Materials of the first pin 151 and the second pin 152 of the decoupling capacitor 150 may be conductive materials, for example, metal materials, and may include any one or more of copper, silver, gold, tin, and the like. It may be understood that, a material of another conductive structure (for example, the conductive layer 120, a conductive pillar 183, a first connection portion 141, a second connection portion 142, or a conductive hole 182) in embodiments of this application may also include the foregoing metal material.

Refer to FIG. 1 and FIG. 2. The first connection portion 141 may be disposed at a conductive layer 120 electrically connected to the first pin 151, and the conductive layer 120 may be electrically connected to the first pin 151 through the first connection portion 141. A second connection portion 142 may be disposed at a conductive layer 120 electrically connected to the second pin 152, and the conductive layer 120 may be electrically connected to the second pin 152 through the second connection portion 142.

For example, the first conductive layer 121 is connected to the first pin 151, and the second conductive layer 122 is connected to the second pin 152. A first connection portion 141 is disposed at the first conductive layer 121. A material of the first connection portion 141 may be the same as the material of the first pin 151, and connection strength between the same materials is high, so that the first connection portion 141 and the first pin 151 are better connected together. A second connection portion 142 is disposed at the second conductive layer 122. A material of the second connection portion 142 may be the same as the material of the second pin 152, and connection strength between the same materials is high, so that the second connection portion 142 and the second pin 152 are better connected together. In some examples, a material of the first conductive layer 121 may be the same as the material of the first connection portion 141, and at least a part of the first conductive layer 121 and the first connection portion 141 may be integrally formed, so that manufacturing processes of the first connection portion 141 and the first conductive layer 121 are simplified. Certainly, the first connection portion 141 and the first conductive layer 121 may alternatively be separately manufactured. For example, a through hole may be formed in the first conductive layer 121, the material of the first connection portion 141 is filled in the through hole, and the first connection portion 141 is formed. The first connection portion 141 is electrically connected to the first conductive layer 121. In some other examples, a material of the first conductive layer 121 may be different from the material of the first connection portion 141, and the first conductive layer 121 and the first connection portion 141 may be separately manufactured. A principle thereof has been described. Details are not described again. For example, the material of the first connection portion 141 is copper, and the material of the first pin 151 is also copper. Alternatively, the material of the first connection portion 141 may be solder paste, and the material of the first pin 151 is tin. It may be understood that, a material of the second conductive layer 122 may be the same as or different from the material of the second connection portion 142. A principle thereof is similar to that of the first connection portion 141 and the first conductive layer 121. Details are not described again.

The following describes a same conductive layer 120 provided in embodiments of this application.

In some embodiments, refer to FIG. 1 and FIG. 2. In the thickness direction of the power module 100, the same conductive layer 120 may include a plurality of stacked sub-conductive layers 130. Because the plurality of sub-conductive layers 130 are disposed, a pattern of the conductive layer 120 formed by the plurality of sub-conductive layers 130 is more complex. In this way, avoidance may be made to some of conducting structures in the power module 100, to better implement signal transmission between components in the power module 100.

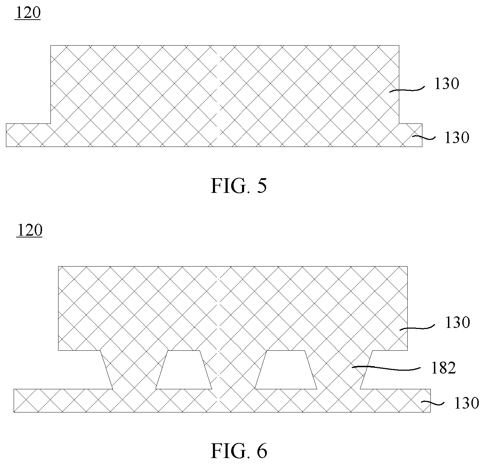

In some examples, refer to FIG. 5. Two adjacent sub-conductive layers 130 may be in direct contact, so that a connection area between the two adjacent sub-conductive layers 130 is large. This can improve connection strength between the two adjacent sub-conductive layers 130, reduce a contact resistance, and improve heat dissipation effect. For example, an area of one of the two adjacent sub-conductive layers 130 may be greater than an area of the other one of the two adjacent sub-conductive layers 130, and the two adjacent sub-conductive layers 130 form a stepped structure, to avoid that the two adjacent sub-conductive layers 130 cannot be in effective contact due to a process or assembly error or the like. In some other examples, refer to FIG. 2 and FIG. 6. Two adjacent sub-conductive layers 130 may be disposed at spacings, and a sub-insulation layer 110 may be disposed between the two adjacent sub-conductive layers 130. The two adjacent sub-conductive layers 130 are electrically connected through the conductive hole 182 provided in the sub-insulation layer 110. A material of the sub-insulation layer 110 located between the two adjacent sub-conductive layers 130 may be the same as or different from a material of a sub-insulation layer 110 located between two adjacent conductive layers 120. Because the two adjacent sub-conductive layers 130 are disposed at spacings, patterns of the two adjacent sub-conductive layers 130 may not affect each other, so that the patterns of the two adjacent sub-conductive layers 130 are independent. This can improve a pattern density of the conductive layer 120 and reduce manufacturing difficulty.

Quantities of sub-conductive layers 130 of any two conductive layers 120 may be the same or different. In the same conductive layer 120, all of two adjacent sub-conductive layers 130 may be in direct contact, or all of two adjacent sub-conductive layers 130 may be disposed at spacings, or a part of two adjacent sub-conductive layers 130 may be in direct contact, and the other part of the two adjacent sub-conductive layers 130 may be disposed at spacings. In the same conductive layer 120, a quantity of sub-conductive layers 130 may be any quantity such as two, three, four, five, or more, and thicknesses of any two sub-conductive layers 130 may be the same or different. In an implementation in which at least two sub-conductive layers 130 of the same conductive layer 120 have different thicknesses. A thinner sub-conductive layer 130 may form a finer pattern, which can better avoid mutual impact between different patterns and improve a pattern density of the sub-conductive layer 130. For example, when the sub-conductive layers 130 are manufactured by using deposition or electroplating processes, the thinner sub-conductive layer 130 has shorter manufacturing time and lower manufacturing difficulty. In addition, a thicker sub-conductive layer 130 can obtain better heat dissipation effect, to improve heat dissipation efficiency of the power module 100.

For example, refer to FIG. 2. In the same conductive layer 120, the plurality of sub-conductive layers 130 may include a first sub-conductive layer 131 and a second sub-conductive layer 132, and a thickness of the first sub-conductive layer 131 may be greater than a thickness of the second sub-conductive layer 132. The first sub-conductive layer 131 has a relatively large thickness, and better heat dissipation effect can be obtained. This improves the heat dissipation efficiency of the power module 100. The second sub-conductive layer 132 has a relatively small thickness, and may form a finer pattern, to improve a pattern density of the sub-conductive layer 130, shorten manufacturing time, and reduce manufacturing difficulty.

For example, refer to FIG. 2. In the first conductive layer 121, a first sub-conductive layer 131 may be located on a side that is of a second sub-conductive layer 132 and that faces away from the second side 101b. A sub-conductive layer 130 with a relatively large thickness (the first sub-conductive layer 131) is closer to a surface of the power module 100. This is more conducive to heat dissipation of the power module 100. A sub-conductive layer 130 with a relatively small thickness (the second sub-conductive layer 132) is closer to a center of the power module 100, and can prepare a finer and higher-density pattern. This is conducive to meeting complex wiring application in the power module 100. And/or, in the second conductive layer 122, a first sub-conductive layer 131 is located on a side that is of a second sub-conductive layer 132 and that faces away from the first side 101a. This is more conducive to heat dissipation of the power module 100 and is also conducive to meeting complex wiring application in the power module 100. A principle thereof is similar to that of the first conductive layer 121. Details are not described again. In this case, even if a heat dissipation member 185 is not disposed, heat dissipation can be effectively implemented by using the first conductive layer 121 and/or the second conductive layer 122. This can simplify a structure of the power module 100 and reduce costs of the power module 100.

For example, refer to FIG. 2. In the same conductive layer 120, the plurality of sub-conductive layers 130 may alternatively include more sub-conductive layers 130, for example, may include a third sub-conductive layer 133, a fourth sub-conductive layer, or a fifth sub-conductive layer. The third sub-conductive layer 133 is used as an example. The third sub-conductive layer 133 may be located between a first sub-conductive layer 131 and a second sub-conductive layer 132, or the third sub-conductive layer 133 may be located on a side that is of a second sub-conductive layer 132 and that faces away from a first sub-conductive layer 131, or the third sub-conductive layer 133 may be located on a side that is of a first sub-conductive layer 131 and that faces away from a second sub-conductive layer 132. When the third sub-conductive layer 133 is located between the first sub-conductive layer 131 and the second sub-conductive layer 132, or the third sub-conductive layer 133 is located on the side that is of the second sub-conductive layer 132 and that faces away from the first sub-conductive layer 131, a thickness of the third sub-conductive layer 133 may be less than a thickness of the first sub-conductive layer 131. The third sub-conductive layer 133 may be disposed thin, to prepare a finer and higher-density pattern. This is conducive to meeting complex wiring application in the power module 100. When the third sub-conductive layer 133 is located on the side that is of the first sub-conductive layer 131 and that faces away from the second sub-conductive layer 132, a thickness of the third sub-conductive layer 133 may be greater than a thickness of the first sub-conductive layer 131. This is more conducive to heat dissipation of the power module 100. Certainly, the thickness of the third sub-conductive layer 133, the thickness of the first sub-conductive layer 131, and a thickness of the second sub-conductive layer 132 may also meet another relationship. In the same conductive layer 120, the plurality of sub-conductive layers 130 may alternatively include only the first sub-conductive layer 131 and the second sub-conductive layer 132. A region that may be covered by any sub-conductive layer 130 in the same conductive layer 120 includes at least one of the first region 100a and the second region 100b.

For example, refer to FIG. 2. In the first conductive layer 121 and the second conductive layer 122, second sub-conductive layers 132 may be located in the first region 100a and the second region 100b. For example, the second sub-conductive layers 132 in the first region 100a and the second region 100b may be disposed at a same layer and with a same material, so that the second sub-conductive layers 132 in the first region 100a and the second region 100b are simultaneously manufactured, to simplify manufacturing processes of the second sub-conductive layers 132 in the first region 100a and the second region 100b. In addition, the second sub-conductive layer 132 has the relatively small thickness, the manufacturing time of the second sub-conductive layer 132 is short, and a process is simple. Therefore, manufacturing the second sub-conductive layers 132 simultaneously in the first region 100a and the second region 100b has small impact on manufacturing time and difficulty of the conductive layer 120. In addition, the first sub-conductive layer 131 may be located in the first region 100a. Because the first sub-conductive layer 131 has the large thickness and the good heat dissipation effect, and the first component 171 in the first region 100a generates much heat, heat can be dissipated more specifically for the first region 100a. This effectively reduces heat of the power module 100. The first sub-conductive layer 131 may not be disposed in the second region 100b, to reduce a weight of the power module 100 and reduce a thickness of the power module 100 in the second region 100b. Because the second component 172 in the second region 100b generates little heat, even if the first sub-conductive layer 131 is not disposed, heat dissipation of the power module 100 is not affected. The first sub-conductive layer 131 is thick, manufacturing time of the first sub-conductive layer 131 is long, and manufacturing is difficult. Therefore, if the first sub-conductive layer 131 is not disposed in the second region 100b, the manufacturing time of the first sub-conductive layer 131 can be shortened, and manufacturing difficulty of the first sub-conductive layer 131 can be reduced. This is conducive to reducing costs.

For example, refer to FIG. 2. In the third conductive layer 123, a first sub-conductive layer 131 and a second sub-conductive layer 132 may be located in the first region 100a and the second region 100b. Because the third conductive layer 123 is located between two adjacent sub-insulation layers 110, the third conductive layer 123 has large impact on flatness of the insulation layer 101. If a thickness difference between the third conductive layer 123 in the first region 100a and the third conductive layer 123 in the second region 100b is large, the sub-insulation layers 110 on two sides of the third conductive layer 123 in the thickness direction are prone to have poor flatness, and a step is prone to exist. Consequently, difficulty in connecting a conductive layer 120 or a component at each sub-insulation layer 110 is increased. Therefore, the first sub-conductive layer 131 and the second sub-conductive layer 132 of the third conductive layer 123 are disposed in both the first region 100a and the second region 100b, so that flatness of each sub-insulation layer 110 can be improved. This reduces the difficulty in connecting the conductive layer 120 or the component at each sub-insulation layer 110.

For example, refer to FIG. 2. At least a part of the first conductive layer 121 and/or the second conductive layer 122 may be exposed to the surface of the insulation layer 101, a hollow portion in a pattern of the exposed part of the first conductive layer 121 and/or the second conductive layer 122 may be filled with a packaging member 186, and the packaging member 186 may protect the power module 100. For example, the packaging member 186 may not be disposed on a side that is of the first conductive layer 121 and/or the second conductive layer 122 and that faces away from the insulation layer 101, to reduce the thickness of the power module 100, reduce costs of the power module 100, simplify a manufacturing process, and facilitate heat dissipation of the power module 100.

Refer to FIG. 1. It may be understood that, in another embodiment, the same layer of the conductive layer 120 may alternatively be a single-layer structure, so that a structure of the conductive layer 120 is simple, and a manufacturing process of the conductive layer 120 is simplified.

The following describes the heat dissipation member 185 provided in embodiments of this application.

Refer to FIG. 1 and FIG. 2. The power module 100 may include a heat dissipation member 185. The heat dissipation member 185 may be disposed on at least one of the side that is of the first conductive layer 121 and that faces away from the second conductive layer 122 and the side that is of the second conductive layer 122 and that faces away from the first conductive layer 121. Embodiments of this application are described by using an example in which heat dissipation members 185 are disposed on a side that is of the first conductive layer 121 and that faces away from the insulation layer 101 and a side that is of the second conductive layer 122 and that faces away from the insulation layer 101.

The heat dissipation member 185 may be located in at least one of the first region 100a and the second region 100b. For example, the heat dissipation member 185 may be disposed only in the first region 100a. The sum of the powers of all the first components 171 is greater than the sum of the powers of all the second components 172. Therefore, if the heat dissipation member 185 is disposed in the first region 100a, heat dissipation of the first component 171 can be implemented in a targeted manner. This effectively reduces a temperature of the power module 100, and avoids impact of a high temperature on performance of the power module 100. The second region 100b generates little heat, so that the heat dissipation member 185 may not be disposed. This can reduce a disposing area of the heat dissipation member 185 and costs of the heat dissipation member 185, reduce the weight of the power module 100, and reduce the thickness of the power module 100 in the second region 100b.

For example, the heat dissipation member 185 may include a heat dissipation panel. The heat dissipation panel may be a metal plate made of a metal material such as aluminum, copper, or steel, or the heat dissipation panel may be a non-metal plate made of a non-metal material such as ceramic or quartz. Alternatively, the heat dissipation member 185 may be a vapor chamber (VC), and heat dissipation effect of the vapor chamber is good. Alternatively, the heat dissipation member 185 may be a cold plate. Alternatively, the heat dissipation member 185 may be made of a flexible thermally conductive material, to avoid mutual wear between the heat dissipation member 185 and another mechanical member in an assembly process. Certainly, the heat dissipation member 185 may alternatively be another heat dissipation apparatus. This is not limited in embodiments of this application. The heat dissipation member 185 may include one or more of the following: the foregoing heat dissipation panels, the foregoing vapor chambers, the foregoing cold plates, or the like that are stacked. Because heat dissipation members 185 are disposed on both sides of the power module 100 in the first region 100a in the thickness direction, a heat dissipation area of the power module 100 is large. This helps improve heat dissipation effect.

In some examples, a heat dissipation member 185 located on the side that is of the first conductive layer 121 and that faces away from the second conductive layer 122 may be in direct contact with the surface of the first conductive layer 121. A heat conduction path between the first conductive layer 121 and the heat dissipation member 185 is short, so that heat can be transferred to the heat dissipation member 185 quickly. This helps improve heat dissipation efficiency. In some other examples, refer to FIG. 1. A heat dissipation member 185 located on the side that is of the first conductive layer 121 and that faces away from the second conductive layer 122 may be in indirect contact with the surface of the first conductive layer 121 through a thermally conductive insulation layer 184, and the thermally conductive insulation layer 184 may further be filled in a hollow portion of a pattern of the first conductive layer 121. The thermally conductive insulation layer 184 can effectively electrically isolate the first conductive layer 121 from another external mechanical member (for example, the circuit board), so that when the power module 100 is installed on the circuit board, insulation processing does not need to be performed between the circuit board and the first conductive layer 121. This can simplify an installation process between the power module 100 and the circuit board. The thermally conductive insulation layer 184 may further transfer the heat of the first conductive layer 121 to the heat dissipation member 185, to effectively implement heat dissipation. In addition, a heat dissipation member 185 located on the side that is of the second conductive layer 122 and that faces away from the first conductive layer 121 may be in direct contact with the surface of the second conductive layer 122, or a heat dissipation member 185 located on the side that is of the second conductive layer 122 and that faces away from the first conductive layer 121 may be in indirect contact with the surface of the second conductive layer 122 through the thermally conductive insulation layer 184. A principle thereof has been described. Details are not described again. The thermally conductive insulation layer 184 may be located only in the first region 100a, which helps reduce the thickness of the power module 100 in the second region 100b and reduce costs; or the thermally conductive insulation layer 184 may be located in both the first region 100a and the second region 100b.

It may be understood that, because the first component 171 is embedded in the insulation layer 101, a difference between a distance from the first component 171 to a heat dissipation member 185 on the first side 101a and a distance from the first component 171 to a heat dissipation member 185 on the second side 101b is small. A heat transfer path from the first component 171 to the heat dissipation member 185 on the first side 101a is close to a heat transfer path from the first component 171 to the heat dissipation member 185 on the second side 101b. In this way, heat dissipation of the power module 100 can be effectively implemented on both sides. Certainly, the heat dissipation member 185 may alternatively not be disposed in the power module 100, and the heat of the power module 100 is dissipated by using the exposed first conductive layer 121 and/or second conductive layer 122.

The following describes the conductive pillar 183 provided in embodiments of this application.

Refer to FIG. 1 and FIG. 2. The power module 100 may include the conductive pillar 183. A sub-insulation layer 110 may have a third accommodation cavity 163, and one third accommodation cavity 163 may be located in one sub-insulation layer 110, or may be located in a plurality of adjacent sub-insulation layers 110. A principle thereof is similar to that of the first accommodation cavity 161. Details are not described again. The conductive pillar 183 may be located in the third accommodation cavity 163, and two conductive layers 120 adjacent to the sub-insulation layer 110 at which the conductive pillar 183 is disposed are electrically connected to the conductive pillar 183. The two adjacent conductive layers 120 are electrically connected through the conductive pillar 183, so that signal transmission between the two adjacent conductive layers 120 can be implemented. If a material of the conductive pillar 183 is a metal material, thermal conductivity of the conductive pillar 183 is better than thermal conductivity of the insulation layer 101, so that the heat dissipation efficiency of the power module 100 can be effectively improved.

It may be understood that, when any one of the first component 171, the second component 172, the decoupling capacitor 150, the conductive pillar 183, or the like is connected to the conductive layer 120. The connection may be direct connection, connection through the conductive hole 182, or connection through another conductive structure. This is not limited in embodiments of this application.

In descriptions of embodiments of this application, it should be noted that, unless otherwise clearly specified and limited, terms "mount", "link", and "connect" should be understood in a broad sense. For example, the terms may indicate fixed connection, indirect connection through an intermediate medium, communication inside two elements, or an interaction relationship between two elements. A person of ordinary skill in the art may understand specific meanings of the foregoing terms in embodiments of this application based on a specific case.

Terms "first", "second", "third", "fourth", and the like (if exist) are intended to distinguish between similar objects but do not necessarily indicate a specific order or sequence.

## Claims

1. A power module (100), comprising: an insulation layer (101), a plurality of conductive layers (120), a decoupling capacitor (150), and a plurality of first components (171), wherein the insulation layer (101) comprises a plurality of sub-insulation layers (110) stacked in a thickness direction of the power module, and the sub-insulation layer (110) is disposed between every two adjacent conductive layers;
the power module (100) comprises a first region (100a), the sub-insulation layer (110) located in the first region has a first accommodation cavity (161), the first component (171) is located in the first accommodation cavity (161), the conductive layer adjacent to the sub-insulation layer at which the first component (171) is disposed is electrically connected to the first component, and at least some of the first components are stacked in the thickness direction of the power module; and
the insulation layer located in the first region has an auxiliary accommodation cavity (164), the decoupling capacitor (150) is located in the auxiliary accommodation cavity (164), a first pin (151) of the decoupling capacitor (150) is electrically connected to one layer of the plurality of conductive layers, and a second pin (152) of the decoupling capacitor (150) is electrically connected to another layer of the plurality of conductive layers.

2. The power module (100) according to claim 1, wherein the insulation layer comprises a first side (101a) and a second side (101b) that are disposed opposite to each other in the thickness direction of the power module (100), and the plurality of conductive layers comprise a first conductive layer (121), a second conductive layer (122), and at least one third conductive layer (123); and
the first conductive layer (121) is located on the first side (101a), the second conductive layer (122) is located on the second side (101b), and the third conductive layer (123) is located between the first conductive layer (121) and the second conductive layer (122).

3. The power module (100) according to claim 2, wherein that the plurality of conductive layers comprise the at least one third conductive layer (123) comprises:
there is one third conductive layer (123), the plurality of sub-insulation layers comprise a first sub-insulation layer (111) and a second sub-insulation layer (112), the first sub-insulation layer (111) is located between the first conductive layer (121) and the third conductive layer (123), and the second sub-insulation layer (112) is located between the second conductive layer (122) and the third conductive layer (123);
the plurality of first components comprise a first transistor (171a) and a second transistor (171b), the first transistor (171a) is located at the first sub-insulation layer (111), and the second transistor (171b) is located at the second sub-insulation layer (112); and
a first electrode and a control electrode of the first transistor (171a) are electrically connected to the first conductive layer (121), a second electrode of the first transistor (171a) is electrically connected to a first electrode of the second transistor (171b) through the third conductive layer (123), a control electrode of the second transistor (!71b) is electrically connected to the third conductive layer (123), and a second electrode of the second transistor (171b) is electrically connected to the second conductive layer (122).

4. The power module (100) according to claim 3, wherein that a first pin (151) of the decoupling capacitor (150) is electrically connected to one layer of the plurality of conductive layers, and a second pin (152) of the decoupling capacitor (150) is electrically connected to another layer of the plurality of conductive layers comprises:
the first pin (151) of the decoupling capacitor (150) is electrically connected to the first electrode of the first transistor (171a) through the first conductive layer (121), and the second pin (152) of the decoupling capacitor (150) is electrically connected to the second electrode of the second transistor (171b) through the second conductive layer (122).

5. The power module (100) according to any one of claims 1 to 4, wherein the power module (100) further comprises an insulation fastener (181), and the insulation fastener (181) is located between the decoupling capacitor (150) and a cavity wall of the auxiliary accommodation cavity (164).

6. The power module (100) according to any one of claims 1 to 5, wherein the power module (100) further comprises a first connection portion and a second connection portion, the first connection portion is disposed at the conductive layer electrically connected to the first pin (151), the first connection portion is electrically connected to the first pin (151), and a material of the first connection portion is the same as a material of the first pin (151); and
the second connection portion is disposed at the conductive layer electrically connected to the second pin (152), the second connection portion is electrically connected to the second pin (152), and a material of the second connection portion is the same as a material of the second pin (152).

7. The power module (100) according to any one of claims 2 to 4, wherein the conductive layer comprises a plurality of sub-conductive layers stacked in the thickness direction of the power module; and
two adjacent sub-conductive layers are in contact; or
two adjacent sub-conductive layers are disposed at spacings, the sub-insulation layer is disposed between the two adjacent sub-conductive layers, and the two adjacent sub-conductive layers are electrically connected through a conductive hole provided in the sub-insulation layer.

8. The power module (100) according to claim 7, wherein a plurality of sub-conductive layers of a same conductive layer comprise a first sub-conductive layer (131) and a second sub-conductive layer (132), and a thickness of the first sub-conductive layer (131) is greater than a thickness of the second sub-conductive layer (132).

9. The power module (100) according to claim 8, wherein a first sub-conductive layer (131) of the first conductive layer (121) is located on a side that is of a second sub-conductive layer (132) of the first conductive layer (!21) and that faces away from the second side; and
a first sub-conductive layer (131) of the second conductive layer (122) is located on a side that is of a second sub-conductive layer (132) of the second conductive layer (122) and that faces away from the first side.

10. The power module (100) according to claim 8, wherein the power module (100) further comprises a plurality of second components (172), the power module (100) comprises a second region (100b), the second region (100b) is located on at least one side of the first region (100a), the second component (172) is located in the second region (100b), and the second component (172) is electrically connected to the first component (171) through the conductive layer; and
a sum of powers of all the first components (171) is greater than a sum of powers of all the second components (172).

11. The power module (100) according to claim 10, wherein the power module (100) further comprises a second accommodation cavity (162), the second accommodation cavity (162) is located at a sub-insulation layer in the second region (100b), and the second component (172) is located in the second accommodation cavity (162); or
the second component (172) is located on a side that is of at least one of the first conductive layer (121) and the second conductive layer (122) and that faces away from the insulation layer; or
the power module (100) further comprises a second accommodation cavity (162), wherein the second accommodation cavity (162) is located at the sub-insulation layer in the second region (100b), some of the second components (172) are located in the second accommodation cavity (162), and the others of the second components (172) are located on a side that is of at least one of the first conductive layer (121) and the second conductive layer (122) and that faces away from the insulation layer.

12. The power module (100) according to claim 10, wherein respective first sub-conductive layers of the first conductive layer (121) and the second conductive layer (122) are all located in the first region (100a), and respective second sub-conductive layers of the first conductive layer (121) and the second conductive layer (122) are all located in the first region (100a) and the second region (100b); and
a first sub-conductive layer and a second sub-conductive layer of the third conductive layer (123) are located in the first region (100a) and the second region (100b).

13. The power module (100) according to any one of claims 2 to 4, wherein the power module (100) comprises a heat dissipation member (185), the heat dissipation member (185) is disposed on a side that is of the first conductive layer (121) and the second conductive layer (122) and that faces away from the insulation layer, and the heat dissipation member (185) is located in the first region (100a).

14. The power module (100) according to any one of claims 1 to 13, wherein the power module (100) comprises a conductive pillar (183), the sub-insulation layer has a third accommodation cavity (163), the conductive pillar (183) is located in the third accommodation cavity (163), and two conductive layers adjacent to the sub-insulation layer at which the conductive pillar (183) is disposed are electrically connected to the conductive pillar (183).

15. A power conversion device, comprising a circuit board and a plurality of power modules according to any one of claims 1 to 14, wherein the plurality of power modules (100) are all disposed on the circuit board.

## Patentansprüche

1. Leistungsmodul (100), das Folgendes umfasst: eine Isolationsschicht (101), mehrere leitende Schichten (120), einen Entkopplungskondensator (150) und mehrere erste Komponenten (171), wobei die Isolationsschicht (101) mehrere Isolationsunterschichten (110), die in einer Dickenrichtung des Leistungsmoduls gestapelt sind, umfasst und die Isolationsunterschicht (110) zwischen sämtlichen zwei benachbarten leitenden Schichten angeordnet ist;
das Leistungsmodul (100) einen ersten Bereich (100a) umfasst, die Isolationsunterschicht (110), die sich im ersten Bereich befindet, einen ersten Aufnahmehohlraum (161) aufweist, die erste Komponente (171) sich im ersten Aufnahmehohlraum (161) befindet, die leitende Schicht, die zu der Isolationsunterschicht, an der die erste Komponente (171) angeordnet ist, benachbart ist, mit der ersten Komponente elektrisch verbunden ist und mindestens einige der ersten Komponenten in der Dickenrichtung des Leistungsmoduls gestapelt sind; und die Isolationsschicht, die sich im ersten Bereich befindet, einen Hilfsaufnahmehohlraum (164) aufweist, der Entkopplungskondensator (150) sich im Hilfsaufnahmehohlraum (164) befindet, ein erster Stift (151) des Entkopplungskondensators (150) mit einer Schicht der mehreren leitenden Schichten elektrisch verbunden ist und ein zweiter Stift (152) des Entkopplungskondensators (150) mit einer weiteren Schicht der mehreren leitenden Schichten elektrisch verbunden ist.

2. Leistungsmodul (100) nach Anspruch 1, wobei die Isolationsschicht eine erste Seite (101a) und eine zweite Seite (101b), die in der Dickenrichtung des Leistungsmoduls (100) einander gegenüber angeordnet sind, umfasst und die mehreren leitenden Schichten eine erste leitende Schicht (121), eine zweite leitende Schicht (122) und mindestens eine dritte leitende Schicht (123) umfassen; und
die erste leitende Schicht (121) sich auf der ersten Seite (101a) befindet, die zweite leitende Schicht (122) sich auf der zweiten Seite (101b) befindet und die dritte leitende Schicht (123) sich zwischen der ersten leitenden Schicht (121) und der zweiten leitenden Schicht (122) befindet.

3. Leistungsmodul (100) nach Anspruch 2, wobei die Tatsache, dass die mehreren leitenden Schichten die mindestens eine dritte leitende Schicht (123) umfassen, Folgendes umfasst:
es ist eine dritte leitende Schicht (123) vorhanden, die mehreren Isolationsunterschichten umfassen eine erste Isolationsunterschicht (111) und eine zweite Isolationsunterschicht (112), die erste Isolationsunterschicht (111) befindet sich zwischen der ersten leitenden Schicht (121) und der dritten leitenden Schicht (123) und die zweite Isolationsunterschicht (112) befindet sich zwischen der zweiten leitenden Schicht (122) und der dritten leitenden Schicht (123);
die mehreren ersten Komponenten umfassen einen ersten Transistor (171a) und einen zweiten Transistor (171b), der erste Transistor (171a) ist an der ersten Isolationsunterschicht (111) angeordnet und der zweite Transistor (171b) ist an der zweiten Isolationsunterschicht (112) angeordnet und
eine erste Elektrode und eine Steuerelektrode des ersten Transistors (171a) sind mit der ersten leitenden Schicht (121) elektrisch verbunden, eine zweite Elektrode des ersten Transistors (171a) ist mit einer ersten Elektrode des zweiten Transistors (171b) durch die dritte leitende Schicht (123) elektrisch verbunden, eine Steuerelektrode des zweiten Transistors (171b) ist mit der dritten leitenden Schicht (123) elektrisch verbunden und eine zweite Elektrode des zweiten Transistors (171b) ist mit der zweiten leitenden Schicht (122) elektrisch verbunden.

4. Leistungsmodul (100) nach Anspruch 3, wobei die Tatsache, dass ein erster Stift (151) des Entkopplungskondensators (150) mit einer Schicht der mehreren leitenden Schichten elektrisch verbunden ist und ein zweiter Stift (152) des Entkopplungskondensators (150) mit einer weiteren Schicht der mehreren leitenden Schichten elektrisch verbunden ist, Folgendes umfasst:
der erste Stift (151) des Entkopplungskondensators (150) ist mit der ersten Elektrode des ersten Transistors (171a) durch die erste leitende Schicht (121) elektrisch verbunden und der zweite Stift (152) des Entkopplungskondensators (150) ist mit der zweiten Elektrode des zweiten Transistors (171b) durch die zweite leitende Schicht (122) elektrisch verbunden.

5. Leistungsmodul (100) nach einem der Ansprüche 1 bis 4, wobei das Leistungsmodul (100) ferner ein Isolationsverbindungselement (181) umfasst und das Isolationsverbindungselement (181) sich zwischen dem Entkopplungskondensator (150) und einer Hohlraumwand des Hilfsaufnahmehohlraums (164) befindet.

6. Leistungsmodul (100) nach einem der Ansprüche 1 bis 5, wobei das Leistungsmodul (100) ferner einen ersten Verbindungsabschnitt und einen zweiten Verbindungsabschnitt umfasst, der erste Verbindungsabschnitt an der leitenden Schicht, die mit dem ersten Stift (151) elektrisch verbunden ist, angeordnet ist, der erste Verbindungsabschnitt mit dem ersten Stift (151) elektrisch verbunden ist und ein Material des ersten Verbindungsabschnitts dasselbe wie ein Material des ersten Stifts (151) ist; und
der zweite Verbindungsabschnitt an der leitenden Schicht, die mit dem zweiten Stift (152) elektrisch verbunden ist, angeordnet ist, der zweite Verbindungsabschnitt mit dem zweiten Stift (152) elektrisch verbunden ist und ein Material des zweiten Verbindungsabschnitts dasselbe wie ein Material des zweiten Stifts (152) ist.

7. Leistungsmodul (100) nach einem der Ansprüche 2 bis 4, wobei die leitende Schicht mehrere leitende Unterschichten umfasst, die in der Dickenrichtung des Leistungsmoduls gestapelt sind; und
zwei benachbarte leitende Unterschichten in Kontakt sind oder
zwei benachbarte leitende Unterschichten in Abständen angeordnet sind, die Isolationsunterschicht zwischen den zwei benachbarten leitenden Unterschichten angeordnet ist und die zwei benachbarten leitenden Unterschichten durch ein leitendes Loch, das in der Isolationsunterschicht bereitgestellt ist, elektrisch verbunden sind.

8. Leistungsmodul (100) nach Anspruch 7, wobei mehrere leitende Unterschichten derselben leitenden Schicht eine erste leitende Unterschicht (131) und eine zweite leitende Unterschicht (132) umfassen und eine Dicke der ersten leitenden Unterschicht (131) größer als eine Dicke der zweiten leitenden Unterschicht (132) ist.

9. Leistungsmodul (100) nach Anspruch 8, wobei eine erste leitende Unterschicht (131) der ersten leitenden Schicht (121) sich auf einer Seite befindet, die von einer zweiten leitenden Unterschicht (132) der ersten leitenden Schicht (121) stammt und die von der zweiten Seite abgewandt ist; und
eine erste leitende Unterschicht (131) der zweiten leitenden Schicht (122) sich auf einer Seite befindet, die von einer zweiten leitenden Unterschicht (132) der zweiten leitenden Schicht (122) stammt und die von der erste Seite abgewandt ist.

10. Leistungsmodul (100) nach Anspruch 8, wobei das Leistungsmodul (100) ferner mehrere zweite Komponenten (172) umfasst, das Leistungsmodul (100) einen zweiten Bereich (100b) umfasst, der zweite Bereich (100b) sich auf mindestens einer Seite des ersten Bereichs (100a) befindet, die zweite Komponente (172) sich im zweiten Bereich (100b) befindet und die zweite Komponente (172) mit der ersten Komponente (171) durch die leitende Schicht elektrisch verbunden ist; und
eine Summe der Leistungen aller ersten Komponenten (171) größer als eine Summe der Leistungen aller zweiten Komponenten (172) ist.

11. Leistungsmodul (100) nach Anspruch 10, wobei das Leistungsmodul (100) ferner einen zweiten Aufnahmehohlraum (162) umfasst, der zweite Aufnahmehohlraum (162) an einer Isolationsunterschicht im zweiten Bereich (100b) angeordnet ist und die zweite Komponente (172) sich im zweiten Aufnahmehohlraum (162) befindet; oder
die zweite Komponente (172) sich auf einer Seite befindet, die von mindestens einer der ersten leitenden Schicht (121) und der zweiten leitenden Schicht (122) stammt und die von der Isolationsschicht abgewandt ist; oder
das Leistungsmodul (100) ferner einen zweiten Aufnahmehohlraum (162) umfasst, wobei der zweite Aufnahmehohlraum (162) an der Isolationsunterschicht im zweiten Bereich (100b) angeordnet ist, ein Teil der zweiten Komponenten (172) sich im zweiten Aufnahmehohlraum (162) befindet und die weiteren der zweiten Komponenten (172) sich auf einer Seite befinden, die von mindestens einer der ersten leitenden Schicht (121) und der zweiten leitenden Schicht (122) stammt und die von der Isolationsschicht abgewandt ist.

12. Leistungsmodul (100) nach Anspruch 10, wobei jeweilige erste leitende Unterschichten der ersten leitenden Schicht (121) und der zweiten leitenden Schicht (122) sich alle im ersten Bereich (100a) befinden und jeweilige zweite leitende Unterschichten der ersten leitenden Schicht (121) und der zweiten leitenden Schicht (122) sich alle in dem ersten Bereich (100a) und dem zweiten Bereich (100b) befinden; und
eine erste leitende Unterschicht und eine zweite leitende Unterschicht der dritten leitenden Schicht (123) sich in dem ersten Bereich (100a) und dem zweiten Bereich (100b) befinden.

13. Leistungsmodul (100) nach einem der Ansprüche 2 bis 4, wobei das Leistungsmodul (100) ein Wärmeabführelement (185) umfasst, das Wärmeabführelement (185) auf einer Seite angeordnet ist, die von der ersten leitenden Schicht (121) und der zweiten leitenden Schicht (122) stammt und die von der Isolationsschicht abgewandt ist, und das Wärmeabführelement (185) sich im ersten Bereich (100a) befindet.

14. Leistungsmodul (100) nach einem der Ansprüche 1 bis 13, wobei das Leistungsmodul (100) eine leitende Säule (183) umfasst, die Isolationsunterschicht einen dritten Aufnahmehohlraum (163) aufweist, die leitende Säule (183) sich im dritten Aufnahmehohlraum (163) befindet und zwei leitende Schichten, die zu der Isolationsunterschicht, an der die leitende Säule (183) angeordnet ist, benachbart sind, mit der leitenden Säule (183) elektrisch verbunden sind.

15. Leistungsumsetzungsvorrichtung, die eine Leiterplatte und mehrere Leistungsmodule nach einem der Ansprüche 1 bis 14 umfasst, wobei die mehreren Leistungsmodule (100) alle auf der Leiterplatte angeordnet sind.

## Revendications

1. Module d'alimentation (100) comprenant : une couche isolante (101), une pluralité de couches conductrices (120), un condensateur de découplage (150) et une pluralité de premiers composants (171), la couche isolante (101) comprenant une pluralité de sous-couches isolantes (110) empilées dans le sens de l'épaisseur du module d'alimentation, et la sous-couche isolante (110) étant disposée entre, à chaque fois, deux couches conductrices adjacentes ;
le module d'alimentation (100) comprenant une première région (100a), la sous-couche isolante (110) située dans la première région comportant une première cavité de logement (161), le premier composant (171) étant situé dans la première cavité de logement (161), la couche conductrice adjacente à la sous-couche isolante au niveau de laquelle le premier composant (171) est disposé étant connectée électriquement au premier composant, et au moins certains des premiers composants étant empilés dans le sens de l'épaisseur du module d'alimentation ; et
la couche isolante située dans la première région comportant une cavité de logement auxiliaire (164), le condensateur de découplage (150) étant situé dans la cavité de logement auxiliaire (164), une première broche (151) du condensateur de découplage (150) étant connectée électriquement à une couche parmi la pluralité de couches conductrices, et une deuxième broche (152) du condensateur de découplage (150) étant connectée électriquement à une autre couche parmi la pluralité de couches conductrices.

2. Module d'alimentation (100) selon la revendication 1, dans lequel la couche isolante comprend un premier côté (101a) et un deuxième côté (101b) qui sont disposés à l'opposé l'un de l'autre dans le sens de l'épaisseur du module d'alimentation (100), et la pluralité de couches conductrices comprend une première couche conductrice (121), une deuxième couche conductrice (122) et au moins une troisième couche conductrice (123) ; et
la première couche conductrice (121) est située sur le premier côté (101a), la deuxième couche conductrice (122) est située sur le deuxième côté (101b), et la troisième couche conductrice (123) est située entre la première couche conductrice (121) et la deuxième couche conductrice (122).

3. Module d'alimentation (100) selon la revendication 2, dans lequel le fait que la pluralité de couches conductrices comprenne l'au moins une troisième couche conductrice (123) comprend les points suivants :
il y a une troisième couche conductrice (123), la pluralité de sous-couches isolantes comprend une première sous-couche isolante (111) et une deuxième sous-couche isolante (112), la première sous-couche isolante (111) est située entre la première couche conductrice (121) et la troisième couche conductrice (123), et la deuxième sous-couche isolante (112) est située entre la deuxième couche conductrice (122) et la troisième couche conductrice (123) ;
la pluralité de premiers composants comprend un premier transistor (171a) et un deuxième transistor (171b), le premier transistor (171a) est situé au niveau de la première sous-couche isolante (111), et le deuxième transistor (171b) est situé au niveau de la deuxième sous-couche isolante (112) ; et
une première électrode et une électrode de commande du premier transistor (171a) sont connectées électriquement à la première couche conductrice (121), une deuxième électrode du premier transistor (171a) est connectée électriquement à une première électrode du deuxième transistor (171b) par l'intermédiaire de la troisième couche conductrice (123), une électrode de commande du deuxième transistor (171b) est connectée électriquement à la troisième couche conductrice (123), et une deuxième électrode du deuxième transistor (171b) est connectée électriquement à la deuxième couche conductrice (122).

4. Module d'alimentation (100) selon la revendication 3, dans lequel le fait qu'une première broche (151) du condensateur de découplage (150) soit connectée électriquement à une couche parmi la pluralité de couches conductrices, et qu'une deuxième broche (152) du condensateur de découplage (150) soit connectée électriquement à une autre couche parmi la pluralité de couches conductrices, comprend les points suivants :
la première broche (151) du condensateur de découplage (150) est connectée électriquement à la première électrode du premier transistor (171a) par l'intermédiaire de la première couche conductrice (121), et la deuxième broche (152) du condensateur de découplage (150) est connectée électriquement à la deuxième électrode du deuxième transistor (171b) par l'intermédiaire de la deuxième couche conductrice (122).

5. Module d'alimentation (100) selon l'une quelconque des revendications 1 à 4, dans lequel le module d'alimentation (100) comprend en outre une fixation isolante (181), et la fixation isolante (181) est située entre le condensateur de découplage (150) et une paroi de cavité de la cavité de logement auxiliaire (164).

6. Module d'alimentation (100) selon l'une quelconque des revendications 1 à 5, dans lequel le module d'alimentation (100) comprend en outre une première partie de connexion et une deuxième partie de connexion, la première partie de connexion est disposée au niveau de la couche conductrice connectée électriquement à la première broche (151), la première partie de connexion est connectée électriquement à la première broche (151), et le matériau de la première partie de connexion est le même que le matériau de la première broche (151) ; et
la deuxième partie de connexion est disposée au niveau de la couche conductrice connectée électriquement à la deuxième broche (152), la deuxième partie de connexion est connectée électriquement à la deuxième broche (152), et le matériau de la deuxième partie de connexion est le même que le matériau de la deuxième broche (152).

7. Module d'alimentation (100) selon l'une quelconque des revendications 2 à 4, dans lequel la couche conductrice comprend une pluralité de sous-couches conductrices empilées dans le sens de l'épaisseur du module d'alimentation ; et
deux sous-couches conductrices adjacentes sont en contact ; ou
deux sous-couches conductrices adjacentes sont disposées suivant certains intervalles, la sous-couche isolante est disposée entre les deux sous-couches conductrices adjacentes, et les deux sous-couches conductrices adjacentes sont connectées électriquement par l'intermédiaire d'un trou conducteur pratiqué dans la sous-couche isolante.

8. Module d'alimentation (100) selon la revendication 7, dans lequel une pluralité de sous-couches conductrices d'une même couche conductrice comprennent une première sous-couche conductrice (131) et une deuxième sous-couche conductrice (132), et l'épaisseur de la première sous-couche conductrice (131) est supérieure à l'épaisseur de la deuxième sous-couche conductrice (132).

9. Module d'alimentation (100) selon la revendication 8, dans lequel une première sous-couche conductrice (131) de la première couche conductrice (121) est située sur un côté qui est celui d'une deuxième sous-couche conductrice (132) de la première couche conductrice (121) et qui est opposé au deuxième côté ; et
une première sous-couche conductrice (131) de la deuxième couche conductrice (122) est située sur un côté qui est celui d'une deuxième sous-couche conductrice (132) de la deuxième couche conductrice (122) et qui est opposé au premier côté.

10. Module d'alimentation (100) selon la revendication 8, dans lequel le module d'alimentation (100) comprend en outre une pluralité de deuxièmes composants (172), le module d'alimentation (100) comprend une deuxième région (100b), la deuxième région (100b) est située sur au moins un côté de la première région (100a), le deuxième composant (172) est situé dans la deuxième région (100b), et le deuxième composant (172) est connecté électriquement au premier composant (171) par l'intermédiaire de la couche conductrice ; et
la somme des puissances de tous les premiers composants (171) est supérieure à la somme des puissances de tous les deuxièmes composants (172).

11. Module d'alimentation (100) selon la revendication 10, dans lequel le module d'alimentation (100) comprend en outre une deuxième cavité de logement (162), la deuxième cavité de logement (162) est située au niveau d'une sous-couche isolante dans la deuxième région (100b), et le deuxième composant (172) est situé dans la deuxième cavité de logement (162) ; ou
le deuxième composant (172) est situé sur un côté qui est au moins l'un de la première couche conductrice (121) et de la deuxième couche conductrice (122) et qui est opposé à la couche isolante ; ou
le module d'alimentation (100) comprend en outre une deuxième cavité de logement (162), où la deuxième cavité de logement (162) est située au niveau de la sous-couche isolante dans la deuxième région (100b), certains des deuxièmes composants (172) sont situés dans la deuxième cavité de logement (162), et les autres des deuxièmes composants (172) sont situés sur un côté qui est au moins l'un de la première couche conductrice (121) et de la deuxième couche conductrice (122) et qui est opposé à la couche isolante.

12. Module d'alimentation (100) selon la revendication 10, dans lequel des premières sous-couches conductrices respectives de la première couche conductrice (121) et de la deuxième couche conductrice (122) sont toutes situées dans la première région (100a), et des deuxièmes sous-couches conductrices respectives de la première couche conductrice (121) et de la deuxième couche conductrice (122) sont toutes situées dans la première région (100a) et la deuxième région (100b) ; et
une première sous-couche conductrice et une deuxième sous-couche conductrice de la troisième couche conductrice (123) sont situées dans la première région (100a) et la deuxième région (100b).

13. Module d'alimentation (100) selon l'une quelconque des revendications 2 à 4, dans lequel le module d'alimentation (100) comprend un élément de dissipation thermique (185), l'élément de dissipation thermique (185) est disposé sur un côté qui est celui de la première couche conductrice (121) et de la deuxième couche conductrice (122) et qui est opposé à la couche isolante, et l'élément de dissipation thermique (185) est situé dans la première région (100a).

14. Module d'alimentation (100) selon l'une quelconque des revendications 1 à 13, dans lequel le module d'alimentation (100) comprend un pilier conducteur (183), la sous-couche isolante comporte une troisième cavité de logement (163), le pilier conducteur (183) est situé dans la troisième cavité de logement (163), et deux couches conductrices adjacentes à la sous-couche isolante au niveau desquelles le pilier conducteur (183) est disposé sont connectées électriquement au pilier conducteur (183).

15. Dispositif de conversion d'alimentation, comprenant une carte de circuit imprimé et une pluralité de modules d'alimentation selon l'une quelconque des revendications 1 à 14, dans lequel la pluralité de modules d'alimentation (100) sont tous disposés sur la carte de circuit imprimé.
